# EUROPEAN PATENT APPLICATION

(11) **EP 3 951 007 A1**
(43) Date of publication of application: **09.02.2022**
(21) Application number: 20785394.6
(22) Date of filing: 18.03.2020
(51) Int. Cl.: C23C 16/42, B32B 9/00, B65D 23/08, C23C 16/40, C23C 16/455

(54) **RESIN-MADE PACKAGING CONTAINER HAVING COMPOSITE SILICON OXIDE FILM OR COMPOSITE METAL OXIDE FILM, AND METHOD FOR MANUFACTURING SAME**

(30) Priority: 03.04.2019 JP 2019071267
(71) Applicant: Takemoto Yohki Co. Ltd., Tokyo 111-0035 (JP)
(72) Inventor: TAKEMOTO Emiko, Tokyo 111-0035 (JP); FUJIMORI Hiroshi, Tokyo 111-0035 (JP); YAMADA Natsuki, Tokyo 111-0035 (JP); SAKAMOTO Hitoshi, Tokyo 141-0031 (JP)
(74) Representative: Grünecker Patent- und Rechtsanwälte PartG mbB
(86) International application number: PCT/JP2020/011897
(87) International publication number: WO 2020/203279

(57) **Abstract**

[Object] To provide resin-made packaging containers including a composite silicon oxide film and a composite metal oxide film which have excellent gas barrier properties and water vapor barrier properties which are unlikely to be deteriorated.

[Solution] A resin-made packaging container has a composite silicon oxide film formed by an atomic layer deposition process. The composite silicon oxide film has a first silicon oxide film containing silicon dioxide as a main component, and a second silicon oxide film formed on the first silicon oxide film and having a structure with a higher density than the first silicon oxide film. The second silicon oxide film is a film having a photoelectron spectrum different from that of the first silicon oxide film.

## Description

### Technical Field

The present invention relates to a resin-made packaging container having a composite silicon oxide film or a composite metal oxide film and a method for manufacturing the same.

### Background Art

In recent years, packaging containers made of resins have been used in various fields; resin-made containers are lighter in weight, have lower transport costs, and are more impact-resistant than metal containers and glass containers, but they have the drawbacks of poor chemical resistance, gas barrier properties, and water vapor barrier properties. In particular, in resin containers for high-grade cosmetics and resin containers that contain, for example, chemicals which undergo severe quality control, containers having excellent gas barrier properties and water vapor barrier properties are desired even if a certain degree of cost is spent (PTLs 1 and 2).

In Japanese Patent No. 5795427 (PTL 3), the inventors of the present application have developed a resin-made container having excellent gas barrier properties by forming a metal oxide film (silicon oxide film) with a thickness of 5 nm to 100 nm on an inner surface and/or an outer surface of a resin-made container by an atomic layer deposition process (ALD). Although the ALD process has a drawback in that it takes a long time to deposit a film, the method is excellent in that a uniform metal film can be formed on a container having a complex shape, and is an optimal technique for depositing a film on small-batch and a variety of high-grade resin containers.

However, while the metal oxide film (silicon oxide film) formed by the above invention can maintain excellent gas barrier properties immediately after deposition of the film or in the case of being stored and managed in the unused state, the continuation of use of the resin-made container with the contents such as water or methanol being placed therein results in deterioration of the formed metal oxide film after several weeks to several months and difficulty of maintaining desired gas barrier properties, and the metal oxide film cannot withstand practical application.

It is also conceivable that an aluminum oxide film (alumina film), which has excellent gas barrier properties and water vapor barrier properties, is used as a metal oxide film for resin-made containers; however, in medicines, foods, cosmetics, and the like, since the contents should be kept away from direct contact with the alumina film, it is necessary to perform certain coating on the alumina film by any method. For example, when an alumina film is coated with a silicon dioxide film by the usual ALD process, there is a problem in that the silicon dioxide film easily deteriorates and peels off as in the above case. Furthermore, although the coating by application can also be performed instead of the ALD process, it is difficult to perform complete application to the inside of a resin-made container having a complex shape, and this coating by application is unsuitable for practical use and is not realistic.

Moreover, when an alumina film is used for resin-made containers, it is difficult to remove the alumina film, and there may be a problem in recycling of the resin-made containers.

### Citation List

### Patent Literature

PTL 1: Japanese Unexamined Patent Application Publication No. 2014-65198
PTL 2: Japanese Unexamined Patent Application Publication No. 2009-226861
PTL 3: Japanese Patent No. 5795427

### Summary of Invention

### Technical Problem

An object of the present invention is to solve the problems described above and to provide a resin-made packaging container including a composite silicon oxide film or composite metal oxide film that is not deteriorated for a long period of time and that can maintain excellent gas barrier properties and water vapor barrier properties even in contact with the contents.

### Solution to Problem

To achieve the above object, a first invention of the application provides a resin-made packaging container including a composite silicon oxide film on an inner surface and/or an outer surface of the packaging container, the composite silicon oxide film being a deposited atomic layer, in which the composite silicon oxide film includes a first silicon oxide film containing silicon dioxide as a main component, and a second silicon oxide film formed on the first silicon oxide film and having a structure with a higher density than the first silicon oxide film,
the second silicon oxide film is a film having a photoelectron spectrum different from that of the first silicon oxide film,
has a peak in a range from 102.3 eV to 103.3 eV, and
has a structure of SiOₓ (2 < x), and the first silicon oxide film has a thickness of 18.0 nm or more, more preferably 30.0 nm or more, and the second silicon oxide film has a thickness of 0.6 nm or more.

To achieve the above object, a second invention of the application provides a resin-made packaging container including a composite metal oxide film on an inner surface and/or an outer surface of the packaging container, the composite metal oxide film being a deposited atomic layer, in which the composite metal oxide film includes a base layer formed of an oxide film of a metal selected from the group consisting of aluminum, gallium, germanium, titanium, zirconium, and zinc, a first silicon oxide film formed on the base layer and containing silicon dioxide as a main component, and a second silicon oxide film formed on the first silicon oxide film, the second silicon oxide film is a film having a structure with a higher density than the first silicon oxide film and having a photoelectron spectrum different from that of the first silicon oxide film,
has a peak in a range from 102.3 eV to 103.3 eV, and
has a structure of SiOₓ (2 < x), the base layer has a thickness of 2.0 nm or more, more preferably 5.0 nm or more, and the first silicon oxide film has a thickness of 18.0 nm or more, more preferably 30.0 nm or more, and the second silicon oxide film has a thickness of 0.6 nm or more.

Furthermore, third and fourth inventions of the application provide manufacturing methods for forming the composite silicon oxide film of the first invention and the composite metal oxide film of the second invention, respectively, on resin-made packaging containers.

### Advantageous Effects of Invention

According to the resin-made packaging container according to the first invention of the application, since the second silicon oxide film that has a structure with a higher density than the first silicon oxide film is formed on the first silicon oxide film, the packaging container is not deteriorated for a long period of time and can maintain excellent gas barrier properties even in contact with the contents, and furthermore, volatilization of the contents from the surface of the container to the outside can also be reduced by excellent water vapor barrier properties. In addition, the silicon oxide films formed on the resin container can be peeled off more easily than other metal oxide films and thus are suitable for recycling of the resin container.

Furthermore, according to the resin-made packaging container according to the second invention of the application, a base layer formed of an oxide film of a metal selected from the group consisting of aluminum, gallium, germanium, titanium, zirconium, and zinc, a first silicon oxide film disposed on the base layer, and a second silicon oxide film that is disposed on the first silicon oxide film and that has a structure with a higher density than the first silicon oxide film are formed as a composite metal oxide film. Consequently, although there is a problem in recycling of the resin container, better gas barrier properties are exhibited, volatilization of the contents to the outside is further reduced by better water vapor barrier properties, and these effects can be maintained for a longer period of time.

In addition, films deposited on resin-made packaging containers used for medicines, foods, cosmetics, and the like are required to be colorless and harmless to the human body. While there are many applicable metal oxide films other than silicon oxide films, many of such metal oxide films are not colorless, and look rainbow colors due to the interference of light or look white in some cases if they are stacked to have an excessively large thickness. In view of these points, silicon oxide films are the most preferable and do not have a problem in terms of the cost.

### Brief Description of Drawings

[Fig. 1] Fig. 1 is a sectional view of a composite silicon oxide film according to a first embodiment of the present invention.
[Fig. 2] Fig. 2 is a sectional view of a composite metal oxide film according to a second embodiment of the present invention.
[Fig. 3] Fig. 3 is a sectional view of films formed on a resin-made packaging container (first embodiment).
[Fig. 4] Fig. 4 is a schematic view of an apparatus for forming a silicon oxide film on a resin-made container.
[Fig. 5] Fig. 5 is a schematic view of a water-vapor gas generation unit and an activation unit.
[Fig. 6] Fig. 6 includes graphs of photoelectron spectra using XPS.

### Description of Embodiments

Embodiments of the present invention will be described in detail below.

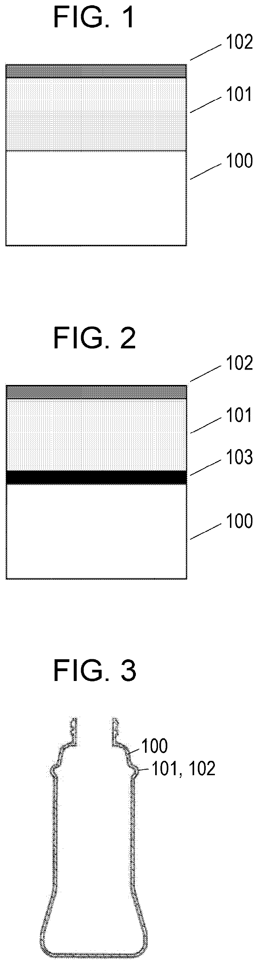

Fig. 1 schematically illustrates the structure of a composite silicon oxide film according to a first embodiment of the present invention. A first silicon oxide film 101 that contains silicon dioxide as a main component is formed on a surface of a resin-made container 100 by an atomic layer deposition process (ALD), and a second silicon oxide film 102 having a higher density than the first silicon oxide film 101 is formed thereon similarly by the atomic layer deposition process (ALD).

While the silicon oxide film in Fig. 1 illustrates an example of a two-layer structure having the first silicon oxide film 101 and the second silicon oxide film 102, the first silicon oxide film 101 and the second silicon oxide film 102 may be further repeatedly formed to provide a four-layer structure, six-layer structure, or the like. See Examples described later for the thickness of each of the films.

Fig. 2 schematically illustrates the structure of a composite metal oxide film according to a second embodiment of the present invention. A base layer 103 formed of an aluminum oxide film (alumina film) is formed on a surface of a resin-made container 100 by an atomic layer deposition process (ALD), a first silicon oxide film 101 is formed thereon similarly by the atomic layer deposition process (ALD), and a second silicon oxide film 102 having a higher density than the first silicon oxide film 101 is further formed thereon.

The material of the base layer 103 can be an oxide of at least one metal selected from the group consisting of gallium, germanium, titanium, zirconium, and zinc besides aluminum.

While the first silicon oxide film 101 and the second silicon oxide film 102 in the second embodiment illustrate an example of a two-layer structure as in the first embodiment, the first silicon oxide film 101 and the second silicon oxide film 102 may be further repeatedly formed and combined with the base layer to provide a total five-layer structure, seven-layer structure, or the like. Alternatively, a three-layer structure including the base layer may be repeatedly formed to provide a six-layer structure, nine-layer structure, or the like. See Examples described later for the thickness of each of the films.

Fig. 3 schematically illustrates a sectional view of a resin-made packaging container having the silicon oxide film according to the first embodiment on each of the inner surface and the outer surface thereof. Although many of resin-made packaging containers have complex shapes as a whole, use of the atomic layer deposition process (ALD) enables a metal film to be firmly formed even on a portion having such a complex shape. Incidentally, the silicon oxide film can be formed only on one of the inner and outer surfaces by masking the inner surface or the outer surface by any method. However, in general, the silicon oxide film is formed on both the inner surface and the outer surface in view of, for example, problems in the manufacturing process and problems in practical use.

The first silicon oxide film according to the first embodiment and the second embodiment is composed of SiO₂, and the second silicon oxide film has a structure of SiOₓ (2 < x) formed to have a higher density than the first silicon oxide film. The method for manufacturing the same will be described below.

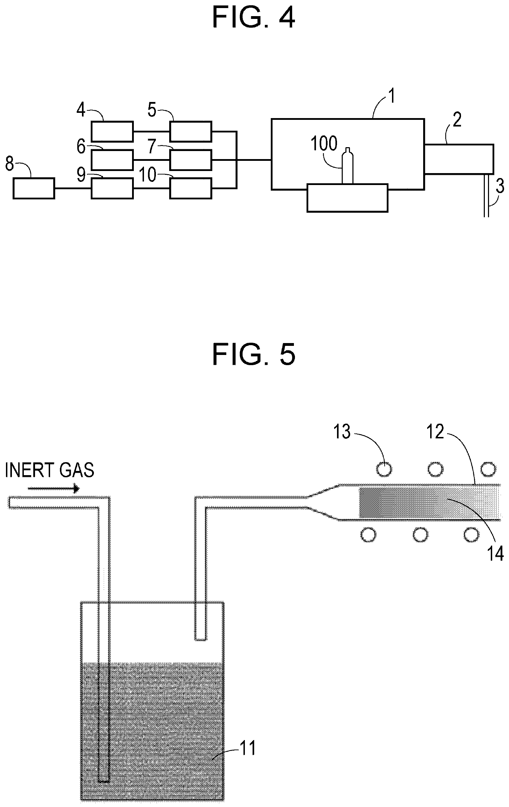

The composite silicon oxide film and the composite metal oxide film according to the present invention are formed by an atomic layer deposition (ALD) apparatus that is schematically illustrated in Fig. 4. A resin-made container 100 which is a workpiece is placed in a reaction vessel 1. In the actual manufacturing, a large number of containers are placed in the reaction vessel 1 and treated in a batch process. The reaction vessel 1 is connected to an exhaust pump 2 and configured to discharge a gas filling the reaction vessel 1 through an exhaust pipe 3. A first metal gas container 4 serving as supply means for supplying a metal gas for silicon film deposition is also connected to the reaction vessel 1 via a first flow rate controller 5. A second metal gas container 6 serving as supply means for supplying a metal gas such as aluminum used in the second embodiment described below is also connected via a second flow rate controller 7. A water vapor or oxygen gas generation unit 8 serving as plasma-gas supply means for supplying a gas obtained by exciting a gas that contains water vapor or oxygen by plasma is further connected via activation units 9 and 10.

Fig. 5 is a schematic view of a water-vapor gas generation unit and an activation unit. In this unit, an inert gas can be humidified by introducing the inert gas from the left side and passing the inert gas through water in a humidifier 11. Argon gas is used as the inert gas. A high-frequency magnetic field is applied to the humidified argon gas in a glass tube 12 by an inductive coil 13 to generate plasma in a region 14, and activated water vapor is generated upon passage of the gas through the region 14 and is fed to the reaction vessel 1. For example, the electromagnetic energy applied by the inductive coil 13 is 20 W, and the frequency is 13.56 MHz.

The above-described apparatus is used to form a first silicon oxide film 101 that is deposited on an atomic level on both surfaces on the inside and the outside of the resin-made container 100 by repeating a series of steps of filling the reaction vessel 1 with a silicon molecular gas, introducing plasmatized water vapor, and introducing ozone. Note that ozone supply means does not necessarily have to be provided, and the step of introducing ozone does also not necessarily have to be performed.

A second silicon oxide film 102 is further formed on the first silicon oxide film 101, which has been formed in the above steps, by a method in which, in the above steps, the electric power for generating plasma is increased, or the time taken for introduction of water vapor or oxygen excited by plasma is increased. The formed second silicon oxide film has a higher density than the first silicon oxide film 101 and has a structure of SiOₓ (2 < x).

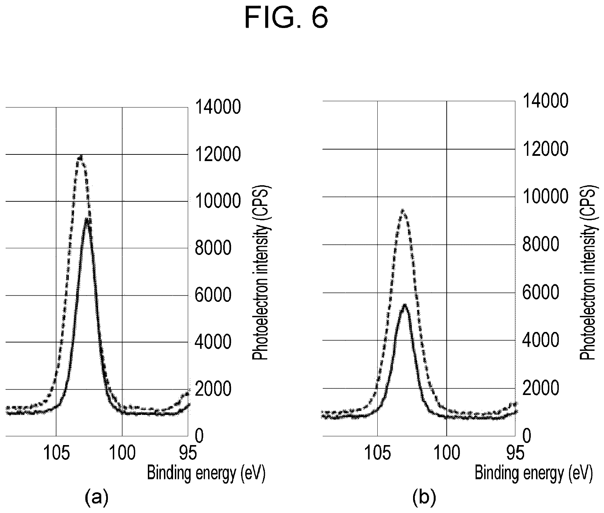

The first silicon oxide film 101 and the second silicon oxide film 102 are each a silicon oxide film but have a difference in photoelectron spectrum as shown in Fig. 6. Fig. 6(a) includes photoelectron spectra observed by X-ray photoelectron spectroscopy (XPS), where the dotted line indicates the first silicon oxide film 101, and the solid line indicates the second silicon oxide film 102.

The first silicon oxide film 101 and the second silicon oxide film 102 were deposited on the same substrate, the substrate was subjected to an Ar etching process for 10 minutes to remove the silicon oxide film on the surface, thereby removing the second silicon oxide film 102, and the photoelectron spectrum of the first silicon oxide film 101 was then measured. At the same time, the measurement results of a substrate having the first silicon oxide film 101 alone are shown in Fig. 6(b) for comparison. Also with regard to the case of having the first silicon oxide film 101 alone, a similar Ar etching process was performed to remove the film on the surface, and the film structures were compared. In the figure, the line represented by the solid line indicates the measured values of the surface, and the line represented by the dotted line indicates the measured values of the inside after etching.

While Fig. 6(b), which shows the case of having the first silicon oxide film 101 alone, shows that the shape of the spectrum having a center at 103.2 eV does not change even when the film of the surface is removed by Ar etching, Fig. 6(a) shows that the shape of the spectrum is changed by removing the second silicon oxide film 102 and changed to a peak having a center at 103.2 eV, as in Fig. 6(b). Accordingly, the results show that the substance having a peak in the range of 102.3 eV indicated by the solid line in Fig. 6(a) to 103.3 eV is the second silicon oxide film 102.

The spectrum of the second silicon oxide film 102 indicated by the solid line in Fig. 6(a) is constituted by a combination of a plurality of spectra of silicon and shows, in particular, a strong peak at 102.8 eV. This difference is due to the difference in chemical bonding state at the periphery of silicon atoms and shows a chemical shift to the direction of a higher density.

As described above, when the second silicon oxide film 102 that is dense and has a high density is further formed on the first silicon oxide film 101 formed on a surface of the resin-made container 100, excellent gas barrier properties and water vapor barrier properties are exhibited, and deterioration of the film due to contact with the contents in the container can be reduced.

Examples of the resin serving as the raw material of the resin-made container include, but are not particularly limited to, polyethylene, polypropylene, polyethylene terephthalate, polystyrene, acrylonitrile-styrene, polyvinyl chloride, cycloolefin polymers, and olefin copolymers.

The method for forming the composite metal oxide film according to the second embodiment is basically the same as the apparatus and the method for forming the composite silicon oxide film according to the first embodiment, except that, before the formation of the first silicon oxide film, an oxide film of at least one metal selected from the group consisting of aluminum, gallium, germanium, titanium, zirconium, and zinc (base layer 103) is formed on a surface of the resin-made container 100, and the first silicon oxide film 101 and, in addition, the second silicon oxide film 102 are then formed by the same method as in the first embodiment.

Based on the first embodiment and the second embodiment described above, some Examples were prepared, tests to compare with Comparative Examples were performed, and gas barrier properties, water vapor barrier properties, and deterioration properties of films were compared as described below.

Note that resin-made packaging containers that contain chemicals, foods, or cosmetics as the contents are required to have an oxygen permeability of at least 0.002 (cc/pkg·day·atm) or less immediately after manufacturing and an oxygen permeability of at least 0.004 (cc/pkg·day·atm) or less after a lapse of three months. Furthermore, in the tests, a rate of change in the weight of contents (water vapor barrier property) is required to be at least 1.0% or less after a lapse of three months. These numerical values are defined as Reference Value 1, Reference Value 2, and Reference Value 3. In further particular chemicals, foods, cosmetics, and the like, high gas barrier properties and water vapor barrier properties that sufficiently achieve the above Reference Values are required, and, as described in Examples below, composite films having high gas barrier properties and water vapor barrier properties that sufficiently achieve the Reference Values 1 to 3 can be formed by adjusting the thickness of each film.

### (Preparation of Examples 1 to 9)

A first silicon oxide film 101 of the first embodiment illustrated in Fig. 1 was formed by repeatedly performing deposition at a deposition rate of 0.06 nm/cycle a required number of times using the atomic layer deposition (ALD) apparatus illustrated in Fig. 4 to prepare resin-made containers 100 having a first silicon oxide film 101 with a thickness of 18 nm, 30 nm, or 54 nm. The resin-made containers 100 to be subjected to film deposition are made of a polyethylene terephthalate resin.

Tris(dimethylamino)silane was used as a metal gas in the Examples. The temperature of the resin-made containers 100 was 23°C.

It was demonstrated that the first silicon oxide film 101 was formed on both the inner and outer surfaces of each of the containers, had a substantially uniform thickness over the entire container, and also had a uniform thickness, for example, even on the inner surface of the shoulder and at the bottom corner of the container, where the coverage would be poor if plasma CVD or the like was employed.

Next, the resin-made containers 100 having the first silicon oxide film 101 with a thickness of 18 nm, 30 nm, or 54 nm thereon were each repeatedly subjected to deposition a required number of times at a deposition rate of 0.06 nm/cycle, where the time taken for introduction of water vapor activated by plasma was doubled, to further form a second silicon oxide film 102 with a film thickness of 0.6 nm, 3.0 nm, or 4.8 nm. Thus, resin-made containers of Examples 1 to 9 shown in Table 1 were obtained.

### (Preparation of Comparative Examples 1 to 7)

A polyethylene terephthalate resin-made container used in Examples 1 to 9 but having no film deposited thereon was provided as Comparative Example 1.

A polyethylene terephthalate resin-made container similar to that of Examples 1 to 9 and having only a 30 nm thick silicon oxide film similar to the first silicon oxide film 101 was provided as Comparative Example 2.

A polyethylene terephthalate resin-made container similar to that of Examples 1 to 9 and having only an 8 nm thick aluminum oxide film 103 was provided as Comparative Example 3.

A polyethylene terephthalate resin-made container similar to that of Examples 1 to 9 and having a first silicon oxide film 101 and a second silicon oxide film 102 each having a smaller thickness than Examples 1 to 9 was provided as Comparative Example 4.

Polyethylene terephthalate resin-made containers similar to those of Examples 1 to 9 and having a first silicon oxide film 101 with a thickness of 102 nm and a second silicon oxide film 102 similar to that of Examples 1 to 9 were provided as Comparative Examples 5, 6, and 7.

### (Comparative test 1)

The oxygen permeability of each of the resin-made containers according to Examples 1 to 9 and Comparative Examples 1 to 7 was measured with an OX-TRAN 2/61 multi-sample oxygen permeability measurement device (manufactured by MOCON, Inc.). The measurement was performed in an environment at 23°C and 60% RH (23°C and 0% RH inside the container) using air as a test gas, a jig equipped with an introduction tube and a discharge tube of nitrogen gas was attached to the mouth of each container, nitrogen was introduced from the introduction tube at 10 cc/min., and an amount of oxygen contained in nitrogen discharged from the discharge tube was measured. The measurement results are provided as permeability (cc/pkg·day·atm) for each resin-made container and shown in Table 1.

**Table 1 Oxygen permeation test (immediately after manufacturing)**

| | | Film thickness (nm) | Oxygen permeability (cc/pkg·day·atm) |
|---|---|---|---|
| Example 1 | First silicon oxide film | 18.0 | 0.001938 |
| | Second silicon oxide film | 0.6 | |
| Example 2 | First silicon oxide film | 18.0 | 0.001797 |
| | Second silicon oxide film | 3.0 | |
| Example 3 | First silicon oxide film | 18.0 | 0.001770 |
| | Second silicon oxide film | 4.8 | |
| Example 4 | First silicon oxide film | 30.0 | 0.001262 |
| | Second silicon oxide film | 0.6 | |
| Example 5 | First silicon oxide film | 30.0 | 0.001199 |
| | Second silicon oxide film | 3.0 | |
| Example 6 | First silicon oxide film | 30.0 | 0.001028 |
| | Second silicon oxide film | 4.8 | |
| Example 7 | First silicon oxide film | 54.0 | 0.000296 |
| | Second silicon oxide film | 0.6 | |
| Example 8 | First silicon oxide film | 54.0 | 0.000261 |
| | Second silicon oxide film | 3.0 | |
| Example 9 | First silicon oxide film | 54.0 | 0.000121 |
| | Second silicon oxide film | 4.8 | |
| Comparative Example 1 | No metal oxide film | - | 0.013871 |
| Comparative Example 2 | Only first silicon oxide film | 30.0 | 0.002392 |
| Comparative Example 3 | Only aluminum oxide film | 8.0 | 0.000072 |
| Comparative Example 4 | First silicon oxide film | 3.0 | 0.011990 |
| | Second silicon oxide film | 0.2 | |
| Comparative Example 5 | First silicon oxide film | 102.0 | 0.000081 |
| | Second silicon oxide film | 0.6 | |
| Comparative Example 6 | First silicon oxide film | 102.0 | 0.000080 |
| | Second silicon oxide film | 3.0 | |
| Comparative Example 7 | First silicon oxide film | 102.0 | 0.000077 |
| | Second silicon oxide film | 4.8 | |

Table 1 shows that, in Examples 1 to 9, the oxygen permeability immediately after manufacturing (or in the unused state as a container) sufficiently achieves the above-described Reference Value 1, and the oxygen permeability is remarkably improved compared with Comparative Example 1, which is a pure resin-made container having no metal oxide film thereon. Furthermore, as in Examples 4 to 9, a first silicon oxide film having a large thickness of 30 nm or more enables the oxidation permeability to be more significantly improved.

Note that Comparative Example 2, which has a first silicon oxide film alone, has an excellent gas barrier property immediately after manufacturing but has poor deterioration properties as shown in Comparative tests 2 and 3 described below. It is also apparent from the test result that an aluminum oxide film has a high gas barrier property.

At the level of a thin film of Comparative Example 4, there is a bit of a problem in practical use, whereas at the level of a thick film of Comparative Examples 5 to 7, the quality is excessive in view of a film used for a general resin container, and there is a problem in terms of manufacturing cost.

### (Comparative test 2)

The resin-made containers according to Examples 1 to 9 and Comparative Examples 1 to 7 were filled with water and subjected to an accelerated test at a speed four times as fast as that in the ordinary state in a thermostatic chamber set to 50°C for three months (12-month test in theory), and the oxygen permeability thereof was compared. The results are shown in Table 2.

**Table 2 Oxygen permeation test (water: after three months)**

| | | Film thickness (nm) | Oxygen permeability (cc/pkg·day·atm) | Immediately after manufacturing | Deterioration ratio |
|---|---|---|---|---|---|
| Example 1 | First silicon oxide film | 18.0 | 0.003664 | 0.001938 | 1.89 |
| | Second silicon oxide film | 0.6 | | | |
| Example 2 | First silicon oxide film | 18.0 | 0.003500 | 0.001797 | 1.95 |
| | Second silicon oxide film | 3.0 | | | |
| Example 3 | First silicon oxide film | 18.0 | 0.003589 | 0.001770 | 2.03 |
| | Second silicon oxide film | 4.8 | | | |
| Example 4 | First silicon oxide film | 30.0 | 0.002861 | 0.001262 | 2.27 |
| | Second silicon oxide film | 0.6 | | | |
| Example 5 | First silicon oxide film | 30.0 | 0.002920 | 0.001199 | 2.43 |
| | Second silicon oxide film | 3.0 | | | |
| Example 6 | First silicon oxide film | 30.0 | 0.002676 | 0.001028 | 2.60 |
| | Second silicon oxide film | 4.8 | | | |
| Example 7 | First silicon oxide film | 54.0 | 0.002502 | 0.000296 | 8.46 |
| | Second silicon oxide film | 0.6 | | | |
| Example 8 | First silicon oxide film | 54.0 | 0.002380 | 0.000261 | 9.13 |
| | Second silicon oxide film | 3.0 | | | |
| Example 9 | First silicon oxide film | 54.0 | 0.002343 | 0.000121 | 19.37 |
| | Second silicon oxide film | 4.8 | | | |
| Comparative Example 1 | No metal oxide film | - | 0.014421 | 0.013871 | 1.04 |
| Comparative Example 2 | Only first silicon oxide film | 30.0 | 0.011333 | 0.002392 | 4.74 |
| Comparative Example 3 | Only aluminum oxide film | 8.0 | 0.000507 | 0.000072 | 7.07 |
| Comparative Example 4 | First silicon oxide film | 3.0 | 0.013266 | 0.011990 | 1.11 |
| | Second silicon oxide film | 0.2 | | | |
| Comparative Example 5 | First silicon oxide film | 102.0 | 0.001215 | 0.000081 | 15.09 |
| | Second silicon oxide film | 0.6 | | | |
| Comparative Example 6 | First silicon oxide film | 102.0 | 0.001167 | 0.000080 | 14.57 |
| | Second silicon oxide film | 3.0 | | | |
| Comparative Example 7 | First silicon oxide film | 102.0 | 0.001100 | 0.000077 | 14.20 |
| | Second silicon oxide film | 4.8 | | | |

Table 2 shows that the composite silicon oxide films according to Examples 1 to 9 satisfy the above-described Reference Value 2 of gas barrier properties even when the containers are filled with water for three months (12 months in theory), and that the deterioration ratio (ratio of permeability after test to oxygen permeability immediately after manufacturing) of each of Examples 1 to 8 is less than 10, and the deterioration ratio (deterioration speed) can also be reduced.

Note that Comparative Example 2, which has a first silicon oxide film alone, has an excellent gas barrier property immediately after manufacturing but has a poor deterioration property. Comparative Examples 5 to 7 have excellent gas barrier properties due to the considerably large thickness of the first silicon oxide film but have high deterioration ratios, showing that the effect is reduced compared with the cost necessary for the film deposition.

At the level of a thin film of Comparative Example 4, the Reference Value 2 is not achieved, and there is a problem in practical use.

### (Comparative test 3)

The resin-made containers of Examples 1 to 9 and Comparative Examples 1 to 7 were filled with a 70% aqueous solution of ethanol and subjected to an accelerated test at a speed four times as fast as that in the ordinary state in a thermostatic chamber set to 50°C for three months (12-month test in theory), and the oxygen permeability was compared as in Test example 1. The results are shown in Table 3.

**Table 3 Oxygen permeation test (aqueous solution of ethanol: after three months)**

| | | Film thickness (nm) | Oxygen permeability (cc/pkg·day·atm) | Immediately after manufacturing | Deterioration ratio |
|---|---|---|---|---|---|
| Example 1 | First silicon oxide film | 18.0 | 0.003886 | 0.001938 | 2.00 |
| | Second silicon oxide film | 0.6 | | | |
| Example 2 | First silicon oxide film | 18.0 | 0.003768 | 0.001797 | 2.10 |
| | Second silicon oxide film | 3.0 | | | |
| Example 3 | First silicon oxide film | 18.0 | 0.003747 | 0.001770 | 2.12 |
| | Second silicon oxide film | 4.8 | | | |
| Example 4 | First silicon oxide film | 30.0 | 0.002881 | 0.001262 | 2.28 |
| | Second silicon oxide film | 0.6 | | | |
| Example 5 | First silicon oxide film | 30.0 | 0.002772 | 0.001199 | 2.31 |
| | Second silicon oxide film | 3.0 | | | |
| Example 6 | First silicon oxide film | 30.0 | 0.002920 | 0.001028 | 2.84 |
| | Second silicon oxide film | 4.8 | | | |
| Example 7 | First silicon oxide film | 54.0 | 0.002320 | 0.000296 | 7.85 |
| | Second silicon oxide film | 0.6 | | | |
| Example 8 | First silicon oxide film | 54.0 | 0.002276 | 0.000261 | 8.73 |
| | Second silicon oxide film | 3.0 | | | |
| Example 9 | First silicon oxide film | 54.0 | 0.002269 | 0.000121 | 18.76 |
| | Second silicon oxide film | 4.8 | | | |
| Comparative Example 1 | No metal oxide film | - | 0.015167 | 0.013871 | 1.09 |
| Comparative Example 2 | Only first silicon oxide film | 30.0 | 0.009174 | 0.002392 | 3.84 |
| Comparative Example 3 | Only aluminum oxide film | 8.0 | 0.000812 | 0.000072 | 11.33 |
| Comparative Example 4 | First silicon oxide film | 3.0 | 0.013259 | 0.011990 | 1.11 |
| | Second silicon oxide film | 0.2 | | | |
| Comparative Example 5 | First silicon oxide film | 102.0 | 0.001039 | 0.000081 | 12.91 |
| | Second silicon oxide film | 0.6 | | | |
| Comparative Example 6 | First silicon oxide film | 102.0 | 0.001033 | 0.000080 | 12.91 |
| | Second silicon oxide film | 3.0 | | | |
| Comparative Example 7 | First silicon oxide film | 102.0 | 0.000963 | 0.000077 | 12.43 |
| | Second silicon oxide film | 4.8 | | | |

Table 3 shows that the composite silicon oxide films according to Examples 1 to 9 satisfy the above-described Reference Value 2 of gas barrier properties even when the containers are filled with the aqueous solution of ethanol for three months (12 months in theory), and that the deterioration ratio (ratio of oxygen permeability after test to oxygen permeability immediately after manufacturing) of each of Examples 1 to 8 is less than 10, and the deterioration ratio (deterioration speed) can also be reduced.

### (Comparative test 4)

Each of the resin-made containers of Examples 1 to 9 and Comparative Examples 1 to 7 was filled with a 70% aqueous solution of ethanol up to 80 percent of the container, and the mouth was then hermetically sealed with a cap made of aluminum. Subsequently, an accelerated test was performed at a speed four times as fast as that in the ordinary state in a thermostatic chamber set to 40°C for three months (12-month test in theory), and a weight of each of the containers was measured and compared with a weight before the start of the test to determine the rate of change in weight. The results are shown in Table 4. Note that the change in the whole weight is caused by evaporation of the contents (water) to the outside of the container through the container wall.

**Table 4 Test of change in weight (aqueous solution of ethanol: after three months)**

| | | Film thickness (nm) | Change in weight |
|---|---|---|---|
| Example 1 | First silicon oxide film | 18.0 | 0.98% |
| | Second silicon oxide film | 0.6 | |
| Example 2 | First silicon oxide film | 18.0 | 0.98% |
| | Second silicon oxide film | 3.0 | |
| Example 3 | First silicon oxide film | 18.0 | 0.98% |
| | Second silicon oxide film | 4.8 | |
| Example 4 | First silicon oxide film | 30.0 | 0.92% |
| | Second silicon oxide film | 0.6 | |
| Example 5 | First silicon oxide film | 30.0 | 0.91% |
| | Second silicon oxide film | 3.0 | |
| Example 6 | First silicon oxide film | 30.0 | 0.90% |
| | Second silicon oxide film | 4.8 | |
| Example 7 | First silicon oxide film | 54.0 | 0.83% |
| | Second silicon oxide film | 0.6 | |
| Example 8 | First silicon oxide film | 54.0 | 0.81% |
| | Second silicon oxide film | 3.0 | |
| Example 9 | First silicon oxide film | 54.0 | 0.80% |
| | Second silicon oxide film | 4.8 | |
| Comparative Example 1 | No metal oxide film | - | 1.41% |
| Comparative Example 2 | Only first silicon oxide film | 42.0 | 1.27% |
| Comparative Example 3 | Only aluminum oxide film | 8.0 | 0.33% |
| Comparative Example 4 | First silicon oxide film | 3.0 | 1.38% |
| | Second silicon oxide film | 0.2 | |
| Comparative Example 5 | First silicon oxide film | 102.0 | 0.78% |
| | Second silicon oxide film | 0.6 | |
| Comparative Example 6 | First silicon oxide film | 102.0 | 0.76% |
| | Second silicon oxide film | 3.0 | |
| Comparative Example 7 | First silicon oxide film | 102.0 | 0.76% |
| | Second silicon oxide film | 4.8 | |

As shown in Table 4, the composite silicon oxide films according to Examples 1 to 12 satisfy the above-described Reference Value 3 of the rate of decrease in weight in the state where the containers are filled with the aqueous solution of ethanol for three months (12 months in theory) and show high water vapor barrier properties. It is found that water vapor barrier properties are also poor in the case of having only the first silicon oxide film with a substantial thickness as in Comparative Example 2 and even in the case of a composite film if the composite film has a small thickness as in Comparative Example 4.

As described above, Comparative Examples 4 to 7 are each provided as Comparative Example because they have slightly poor barrier properties or result in an increase in the cost due to excessive film deposition compared with Examples 1 to 9; however, even Comparative Examples 4 to 7 can be provided for practical use depending on the demands of users or the contents. That is, Examples 1 to 9 are merely standard film deposition models, and needless to say, Comparative Examples 4 to 7 may also be provided as Examples of the present invention.

### (Examples 10 to 15)

Resin containers on which an aluminum oxide film with a thickness of 2 nm, 5 nm, 8 nm, 20 nm, 30 nm, or 40 nm was deposited as the base layer 103 according to the second embodiment illustrated in Fig. 2 were prepared using the atomic layer deposition (ALD) apparatus illustrated in Fig. 4. The resin-made containers 100 are made of a polyethylene terephthalate resin. The atomic layer deposition rate of the aluminum oxide film is 0.1 nm per one cycle.

A first silicon oxide film with a thickness of 30 nm and a second silicon oxide film with a thickness of 4.8 nm, which were the same as those in Example 6, were further formed on each of the above resin containers having the aluminum oxide film with a thickness of 2 nm, 5 nm, 8 nm, 20 nm, 30 nm, or 40 nm to provide resin containers of Examples 10, 11, 12, 13, 14, and 15, respectively.

### (Comparison target)

Example 6, which did not have the base layer 103, was used as a comparison target, and the following tests were performed.

### (Comparative test 5)

The oxygen permeability of each of the resin-made containers according to Examples 10 to 13 and Comparative Examples 8 and 9 was measured as in Comparative test 1 with an OX-TRAN 2/61 multi-sample oxygen permeability measurement device (manufactured by MOCON, Inc.). The measurement was performed as in Comparative test 1 in an environment at 23°C and 60% RH (23°C and 0% RH inside the container), a jig equipped with an introduction tube and a discharge tube of nitrogen gas was attached to the mouth of each container, air was used as a test gas, nitrogen was introduced from the introduction tube at 10 cc/min., and an amount of oxygen contained in nitrogen discharged from the discharge tube was measured. The measurement results are provided as permeability (cc/pkg·day·atm) for each resin-made container and shown in Table 5.

**Table 5 Oxygen permeation test (immediately after manufacturing)**

| | | Film thickness (nm) | Oxygen permeability (cc/pkg·day·atm) |
|---|---|---|---|
| Example 6 | First silicon oxide film | 30.0 | 0.001028 |
| | Second silicon oxide film | 4.8 | |
| Example 10 | Base layer (Alumina film) | 2.0 | 0.000834 |
| | First silicon oxide film | 30.0 | |
| | Second silicon oxide film | 4.8 | |
| Example 11 | Base layer (Alumina film) | 5.0 | 0.000171 |
| | First silicon oxide film | 30.0 | |
| | Second silicon oxide film | 4.8 | |
| Example 12 | Base layer (Alumina film) | 8.0 | 0.000062 |
| | First silicon oxide film | 30.0 | |
| | Second silicon oxide film | 4.8 | |
| Example 13 | Base layer (Alumina film) | 20.0 | 0.000054 |
| | First silicon oxide film | 30.0 | |
| | Second silicon oxide film | 4.8 | |
| Example 14 | Base layer (Alumina film) | 30.0 | 0.000051 |
| | First silicon oxide film | 30.0 | |
| | Second silicon oxide film | 4.8 | |
| Example 15 | Base layer (Alumina film) | 40.0 | 0.000053 |
| | First silicon oxide film | 30.0 | |
| | Second silicon oxide film | 4.8 | |

It is found that since Examples 10 to 15 each have, as a base layer, an aluminum oxide film, which has sufficient gas barrier properties even when used alone, the Reference Value 1 is sufficiently achieved, and gas barrier properties are remarkably enhanced compared with Example 6, which is formed of the first silicon oxide film and the second silicon oxide film.

Examples 10 to 15 were further subjected to Comparative tests 6, 7, and 8 which were the same as Comparative tests 2, 3, and 4, respectively. The results are shown in Tables 6, 7, and 8. Incidentally, the comparison with Example 6 was also performed in Tables 6 to 8.

**Table 6 Oxygen permeation test (water: after three months)**

| | | Film thickness (nm) | Oxygen permeability (cc/pkg·day·atm) | Immediately after manufacturing | Deterioration ratio |
|---|---|---|---|---|---|
| Example 6 | First silicon oxide film | 30.0 | 0.002676 | 0.001028 | 2.60 |
| | Second silicon oxide film | 4.8 | | | |
| Example 10 | Base layer (Alumina film) | 2.0 | 0.001750 | 0.000834 | 2.10 |
| | First silicon oxide film | 30.0 | | | |
| | Second silicon oxide film | 4.8 | | | |
| Example 11 | Base layer (Alumina film) | 5.0 | 0.000512 | 0.000171 | 2.99 |
| | First silicon oxide film | 30.0 | | | |
| | Second silicon oxide film | 4.8 | | | |
| Example 12 | Base layer (Alumina film) | 8.0 | 0.000087 | 0.000062 | 1.41 |
| | First silicon oxide film | 30.0 | | | |
| | Second silicon oxide film | 4.8 | | | |
| Example 13 | Base layer (Alumina film) | 20.0 | 0.000084 | 0.000054 | 1.55 |
| | First silicon oxide film | 30.0 | | | |
| | Second silicon oxide film | 4.8 | | | |
| Example 14 | Base layer (Alumina film) | 30.0 | 0.000074 | 0.000051 | 1.45 |
| | First silicon oxide film | 30.0 | | | |
| | Second silicon oxide film | 4.8 | | | |
| Example 15 | Base layer (Alumina film) | 40.0 | 0.000068 | 0.000053 | 1.29 |
| | First silicon oxide film | 30.0 | | | |
| | Second silicon oxide film | 4.8 | | | |

**Table 7 Oxygen permeation test (aqueous solution of ethanol: after three months)**

| | | Film thickness (nm) | Oxygen permeability (cc/pkg·day·atm) | Immediately after manufacturing | Deterioration ratio |
|---|---|---|---|---|---|
| Example 6 | First silicon oxide film | 30.0 | 0.002920 | 0.001028 | 2.84 |
| | Second silicon oxide film | 4.8 | | | |
| Example 10 | Base layer (Alumina film) | 2.0 | 0.001541 | 0.000834 | 1.85 |
| | First silicon oxide film | 30.0 | | | |
| | Second silicon oxide film | 4.8 | | | |
| Example 11 | Base layer (Alumina film) | 5.0 | 0.000360 | 0.000171 | 2.10 |
| | First silicon oxide film | 30.0 | | | |
| | Second silicon oxide film | 4.8 | | | |
| Example 12 | Base layer (Alumina film) | 8.0 | 0.000180 | 0.000062 | 2.91 |
| | First silicon oxide film | 30.0 | | | |
| | Second silicon oxide film | 4.8 | | | |
| Example 13 | Base layer (Alumina film) | 20.0 | 0.000065 | 0.000054 | 1.21 |
| | First silicon oxide film | 30.0 | | | |
| | Second silicon oxide film | 4.8 | | | |
| Example 14 | Base layer (Alumina film) | 30.0 | 0.000068 | 0.000051 | 1.33 |
| | First silicon oxide film | 30.0 | | | |
| | Second silicon oxide film | 4.8 | | | |
| Example 15 | Base layer (Alumina film) | 40.0 | 0.000064 | 0.000053 | 1.21 |
| | First silicon oxide film | 30.0 | | | |
| | Second silicon oxide film | 4.8 | | | |

**Table 8 Test of change in weight (aqueous solution of ethanol: after three months)**

| | | Film thickness (nm) | Change in weight |
|---|---|---|---|
| Example 6 | First silicon oxide film | 30.0 | 0.90% |
| | Second silicon oxide film | 4.8 | |
| Example 10 | Base layer (Alumina film) | 2.0 | 0.78% |
| | First silicon oxide film | 30.0 | |
| | Second silicon oxide film | 4.8 | |
| Example 11 | Base layer (Alumina film) | 5.0 | 0.28% |
| | First silicon oxide film | 30.0 | |
| | Second silicon oxide film | 4.8 | |
| Example 12 | Base layer (Alumina film) | 8.0 | 0.23% |
| | First silicon oxide film | 30.0 | |
| | Second silicon oxide film | 4.8 | |
| Example 13 | Base layer (Alumina film) | 20.0 | 0.20% |
| | First silicon oxide film | 30.0 | |
| | Second silicon oxide film | 4.8 | |
| Example 14 | Base layer (Alumina film) | 30.0 | 0.18% |
| | First silicon oxide film | 30.0 | |
| | Second silicon oxide film | 4.8 | |
| Example 15 | Base layer (Alumina film) | 40.0 | 0.17% |
| | First silicon oxide film | 30.0 | |
| | Second silicon oxide film | 4.8 | |

Since the aluminum oxide films originally have not only high gas barrier properties but also high water vapor barrier properties, as shown in Tables 6, 7, and 8, Examples 10 to 15, which have the structure of base layer + first silicon oxide film + second silicon oxide film, each have a significantly better function than Example 6 and easily satisfy the Reference Values 1 to 3.

As described above, Examples 10 to 15 are each a composite metal oxide film applied to particular resin containers that require extremely high gas barrier properties and water vapor barrier properties, and for resin containers having the so-called standard gas barrier properties, a sufficient effect is achieved by the composite silicon oxide films of Examples 1 to 9. Furthermore, in Examples 10 to 15, since first silicon oxide film + second silicon oxide film are formed on the aluminum oxide film, the top of the aluminum oxide film and the first silicon oxide film are not easily separated from each other even by long-term use.

### (Examples 16 to 19)

In Examples 16 to 19, zinc oxide films were formed as base layers instead of the base layers formed of the aluminum oxide films used in Examples 10 to 15 described above, the thicknesses of the zinc oxide films were 5, 8, 20, and 30 nm, and a first silicon oxide film with a thickness of 30 nm and a second silicon oxide film with a thickness of 4.8 nm were formed on each of the zinc oxide films. The atomic layer deposition rate of the zinc oxide film is 0.2 nm per one cycle.

The resin containers of Examples 10 to 15 were subjected to tests 9, 10, 11, and 12 which were the same as the comparative tests described above. The results are shown in Tables 9, 10, 11, and 12.

**Table 9 Oxygen permeation test (immediately after manufacturing)**

| | | Film thickness (nm) | Oxygen permeability (cc/pkg·day·atm) |
|---|---|---|---|
| Example 13 | Base layer (Zinc oxide film) | 5.0 | 0.0003044 |
| | First silicon oxide film | 30.0 | |
| | Second silicon oxide film | 4.8 | |
| Example 14 | Base layer (Zinc oxide film) | 8.0 | 0.0001064 |
| | First silicon oxide film | 30.0 | |
| | Second silicon oxide film | 4.8 | |
| Example 15 | Base layer (Zinc oxide film) | 20.0 | 0.0000914 |
| | First silicon oxide film | 30.0 | |
| | Second silicon oxide film | 4.8 | |
| Example 16 | Base layer (Zinc oxide film) | 30.0 | 0.0000906 |
| | First silicon oxide film | 30.0 | |
| | Second silicon oxide film | 4.8 | |

**Table 10 Oxygen permeation test (water: after three months)**

| | | Film thickness (nm) | Oxygen permeability (cc/pkg·day·atm) | Immediately after manufacturing | Deterioration ratio |
|---|---|---|---|---|---|
| Example 16 | Base layer (Zinc oxide film) | 5.0 | 0.0026762 | 0.0003044 | 8.79 |
| | First silicon oxide film | 30.0 | | | |
| | Second silicon oxide film | 4.8 | | | |
| Example 17 | Base layer (Zinc oxide film) | 8.0 | 0.0008236 | 0.0001064 | 7.74 |
| | First silicon oxide film | 30.0 | | | |
| | Second silicon oxide film | 4.8 | | | |
| Example 18 | Base layer (Zinc oxide film) | 20.0 | 0.0006177 | 0.0000914 | 6.76 |
| | First silicon oxide film | 30.0 | | | |
| | Second silicon oxide film | 4.8 | | | |
| Example 19 | Base layer (Zinc oxide film) | 30.0 | 0.0005967 | 0.0000906 | 6.58 |
| | First silicon oxide film | 30.0 | | | |
| | Second silicon oxide film | 4.8 | | | |

**Table 11 Oxygen permeation test (aqueous solution of ethanol: after three months)**

| | | Film thickness (nm) | Oxygen permeability (cc/pkg·day·atm) | Immediately after manufacturing | Deterioration ratio |
|---|---|---|---|---|---|
| Example 16 | Base layer (Zinc oxide film) | 5.0 | 0.0029202 | 0.0003044 | 9.59 |
| | First silicon oxide film | 30.0 | | | |
| | Second silicon oxide film | 4.8 | | | |
| Example 17 | Base layer (Zinc oxide film) | 8.0 | 0.0007319 | 0.0001064 | 6.88 |
| | First silicon oxide film | 30.0 | | | |
| | Second silicon oxide film | 4.8 | | | |
| Example 18 | Base layer (Zinc oxide film) | 20.0 | 0.0005528 | 0.0000914 | 6.05 |
| | First silicon oxide film | 30.0 | | | |
| | Second silicon oxide film | 4.8 | | | |
| Example 19 | Base layer (Zinc oxide film) | 30.0 | 0.0005137 | 0.0000906 | 5.67 |
| | First silicon oxide film | 30.0 | | | |
| | Second silicon oxide film | 4.8 | | | |

**Table 12 Weight test (aqueous solution of ethanol: after three months)**

| | | Film thickness (nm) | Change in weight |
|---|---|---|---|
| Example 16 | Base layer (Zinc oxide film) | 5.0 | 0.89% |
| | First silicon oxide film | 30.0 | |
| | Second silicon oxide film | 4.8 | |
| Example 17 | Base layer (Zinc oxide film) | 8.0 | 0.84% |
| | First silicon oxide film | 30.0 | |
| | Second silicon oxide film | 4.8 | |
| Example 18 | Base layer (Zinc oxide film) | 20.0 | 0.77% |
| | First silicon oxide film | 30.0 | |
| | Second silicon oxide film | 4.8 | |
| Example 19 | Base layer (Zinc oxide film) | 30.0 | 0.75% |
| | First silicon oxide film | 30.0 | |
| | Second silicon oxide film | 4.8 | |

Although the resin containers including a zinc oxide film as the base layer have slightly poorer properties than those including an aluminum oxide film, they have higher gas barrier properties and water vapor barrier properties than those including silicon oxide films, and therefore, as shown in Tables 9, 10, 11, and 12, Examples 16 to 19, which have the structure of base layer + first silicon oxide film + second silicon oxide film, each have an excellent function and easily satisfy the Reference Values 1 to 3.

While Examples 10 to 19 describe examples in which the most standard aluminum oxide film and zinc oxide film are formed as the base layer, besides these metal films, the base layer may be, for example, a gallium oxide film, a germanium oxide film, a titanium oxide film, or a zirconium oxide film, and any of these films can also achieve similar effects.

As described above, according to the first invention of the application (including Examples 1 to 9 and Comparative Examples 4 to 7), by using a composite silicon oxide film formed of the first and second silicon oxide films having different structures and characteristics, a metal oxide film that can exhibit high gas barrier properties and water vapor barrier properties for a long period of time can be obtained, and oxidation of the contents and volatilization of the contents to the outside of the container can be markedly suppressed without using an aluminum oxide coating film, which tends to be kept away as a deposited film for resin-made packaging containers. Furthermore, since the composite silicon oxide film is easily peeled off from resin-made containers, it is also suitable for recycling of resin-made containers.

According to the second invention of the application (Examples 10 to 19), by using a composite metal oxide film having the two types of silicon oxide films according to the first invention on a coating film formed of a metal oxide film (such as an aluminum oxide film or a zinc oxide film), the protection of particular contents by resin-made containers can also be realized because the composite metal oxide film has still higher gas barrier properties and water vapor barrier properties than the first invention.

For the metal oxide films that exhibit gas barrier properties, it is possible to use various organometallic compounds that are gasified, such as compounds in which carbon is directly bonded to a metal, compounds in which carbon is bonded to a metal via oxygen, and compounds in which carbon is bonded to a metal via nitrogen, and all compounds that can be used for the existing atomic layer deposition process are applicable. Examples of organometallic gas include organosilicon compounds such as trimethylaminosilane and bisdimethylaminosilane; organozirconium compounds such as trimethylamidozirconium; organotitanium compounds such as titanium isopropoxide and titanium dimethylethylaminotitanium; organogallium compounds such as trimethylgallium; organozinc compounds; organogermanium compounds; and organoaluminum compounds such as trimethylaluminum. In particular, for resin-made packaging containers that contain chemicals, foods, or cosmetics as the contents, silicon oxide films are suitable, and the present invention is an invention dedicated to the silicon oxide films.

### Reference Signs List

- 1: reaction vessel
- 2: exhaust pump
- 3: exhaust pipe
- 4: first metal gas container
- 5: first flow rate controller
- 6: second metal gas container
- 7: second flow rate controller
- 8: water vapor or oxygen gas generation unit
- 9, 10: activation unit
- 11: humidifier
- 12: glass tube
- 13: inductive coil
- 14: plasma generation region
- 100: resin-made container (resin layer)
- 101: first silicon oxide film
- 102: second silicon oxide film
- 103: base layer

## Claims

1. A composite-silicon-oxide-film-equipped resin-made packaging container comprising:
a composite silicon oxide film on an inner surface and/or an outer surface of the packaging container, the composite silicon oxide film being a deposited atomic layer,
wherein the composite silicon oxide film includes
a first silicon oxide film containing silicon dioxide as a main component, and
a second silicon oxide film formed on the first silicon oxide film and having a structure with a higher density than the first silicon oxide film,
the second silicon oxide film is a film having a photoelectron spectrum different from that of the first silicon oxide film,
has a peak in a range from 102.3 eV to 103.3 eV, and
has a structure of SiOₓ (2 < x), and
the first silicon oxide film has a thickness of 18.0 nm or more, preferably 30.0 nm or more, and the second silicon oxide film has a thickness of 0.6 nm or more.

2. The composite-silicon-oxide-film-equipped resin-made packaging container according to Claim 1,
wherein the composite silicon oxide film has a structure in which the first silicon oxide film and the second silicon oxide film are repeatedly formed a plurality of times in an alternating manner.

3. A composite-metal-oxide-film-equipped resin-made packaging container comprising:
a composite metal oxide film on an inner surface and/or an outer surface of the packaging container, the composite metal oxide film being a deposited atomic layer,
wherein the composite metal oxide film includes
a base layer formed of an oxide film of a metal selected from the group consisting of aluminum, gallium, germanium, titanium, zirconium, and zinc,
a first silicon oxide film formed on the base layer and containing silicon dioxide as a main component, and
a second silicon oxide film formed on the first silicon oxide film,
the second silicon oxide film is a film having a structure with a higher density than the first silicon oxide film and having a photoelectron spectrum different from that of the first silicon oxide film,
has a peak in a range from 102.3 eV to 103.3 eV, and
has a structure of SiOₓ (2 < x),
the base layer has a thickness of 2.0 nm or more, preferably 5.0 nm or more, and
the first silicon oxide film has a thickness of 18.0 nm or more, preferably 30.0 nm or more, and the second silicon oxide film has a thickness of 0.6 nm or more.

4. The composite-metal-oxide-film-equipped resin-made packaging container according to Claim 3,
wherein the composite metal oxide film has a structure in which, on the base layer, the first silicon oxide film and the second silicon oxide film are repeatedly formed a plurality of times in an alternating manner.

5. The composite-metal-oxide-film-equipped resin-made packaging container according to Claim 3,
wherein the composite metal oxide film has a structure in which three layers of the base layer, the first silicon oxide film, and the second silicon oxide film are repeatedly formed in this order a plurality of times.

6. A method for forming a composite silicon oxide film on a resin-made packaging container by an atomic layer deposition process, the method comprising:
a step of performing atomic layer deposition in a reaction vessel to form, on the packaging container, a first silicon oxide film containing silicon dioxide as a main component; and
a step of performing atomic layer deposition to form, on the first silicon oxide film, a second silicon oxide film having a structure with a higher density than the first silicon oxide film,
wherein the second silicon oxide film is a film having a photoelectron spectrum different from that of the first silicon oxide film,
has a peak in a range from 102.3 eV to 103.3 eV, and
has a structure of SiOₓ (2 < x), and
the first silicon oxide film has a thickness of 18.0 nm or more, more preferably 30.0 nm or more, and the second silicon oxide film has a thickness of 0.6 nm or more.

7. A method for forming a composite metal oxide film on a resin-made packaging container by an atomic layer deposition process, the method comprising:
a step of performing atomic layer deposition in a reaction vessel to form, on the packaging container, a base layer formed of an oxide film of a metal selected from the group consisting of aluminum, gallium, germanium, titanium, zirconium, and zinc;
a step of performing atomic layer deposition to form, on the base layer, a first silicon oxide film containing silicon dioxide as a main component; and
a step of performing atomic layer deposition to form, on the first silicon oxide film, a second silicon oxide film having a structure with a higher density than the first silicon oxide film,
wherein the second silicon oxide film is a film having the structure with the higher density than the first silicon oxide film and having a photoelectron spectrum different from that of the first silicon oxide film,
has a peak in a range from 102.3 eV to 103.3 eV, and
has a structure of SiOₓ (2 < x),
the base layer has a thickness of 2.0 nm or more, more preferably 5.0 nm or more, and
the first silicon oxide film has a thickness of 18.0 nm or more, more preferably 30.0 nm or more, and the second silicon oxide film has a thickness of 0.6 nm or more.
